Europäisches Patentamt

European Patent Office

Office européen des brevets

(19)

(11) **EP 0 499 589 B1**

(12) **FASCICULE DE BREVET EUROPEEN**

(45) Date de publication et mention
de la délivrance du brevet:
**03.01.1996 Bulletin 1996/01**

(51) Int Cl.6: **G01R 19/20**, H01F 27/42,
G01R 15/18

(21) Numéro de dépôt: **92810102.1**

(22) Date de dépôt: **13.02.1992**

(54) **Dispositif de mesure de courants**

Vorrichtung zum Messen von Strömen

Device for measuring currents

(84) Etats contractants désignés:
**CH DE ES FR GB IT LI**

(30) Priorité: **15.02.1991 CH 481/91**

(43) Date de publication de la demande:
**19.08.1992 Bulletin 1992/34**

(73) Titulaire: **LIAISONS
ELECTRONIQUES-MECANIQUES LEM S.A.
CH-1228 Plan-les-Ouates (CH)**

(72) Inventeur: **Etter, Marcel
CH-1256 Troinex (CH)**

(74) Mandataire: **Hranitzky, Wilhelm Max et al
CH-1202 Genève (CH)**

(56) Documents cités:
**EP-A- 0 356 248       US-A- 3 714 544
US-A- 4 274 051**

# Description

La présente invention concerne un dispositif de mesure de courants selon le préambule de la revendication 1.

Un tel dispositif est connu, par exemple, de la demande de brevet européen publiée sous le No 0 356 248. Le dispositif décrit dans cette demande vise notamment à séparer le courant magnétisant et les courants servant à la mesure, par des moyens qui, dans la pratique, s'avèrent insuffisants et difficiles à maîtriser. De même, les solutions proposées pour compenser d'autres influences, telles que la chute de tension dans l'enroulement secondaire du second transformateur ou la variation des tensions d'offset des amplificateurs, ne s'avèrent pas satisfaisantes et nécessitent des mises au point délicates incompatibles avec une fabrication en série et une utilisation de ces dispositifs dans une large gamme de températures.

La présente invention vise à remédier à ces inconvénients et à fournir un dispositif de mesure permettant d'obtenir un signal de mesure exempt d'effets ou de traces du courant magnétisant et de compenser les influences secondaires sur ce signal de mesure de façon automatique et moyennant un minimum de réglages.

A cet effet, le dispositif selon l'invention présente les particularités décrites dans la partie caractérisante de la revendication 1. La revendication 2 décrit une forme d'exécution pour une application spécifique du dispositif selon l'invention.

L'invention sera mieux comprise à la lumière de la description d'une forme d'exécution particulière donnée à titre d'exemple et illustrée dans le dessin annexé dont

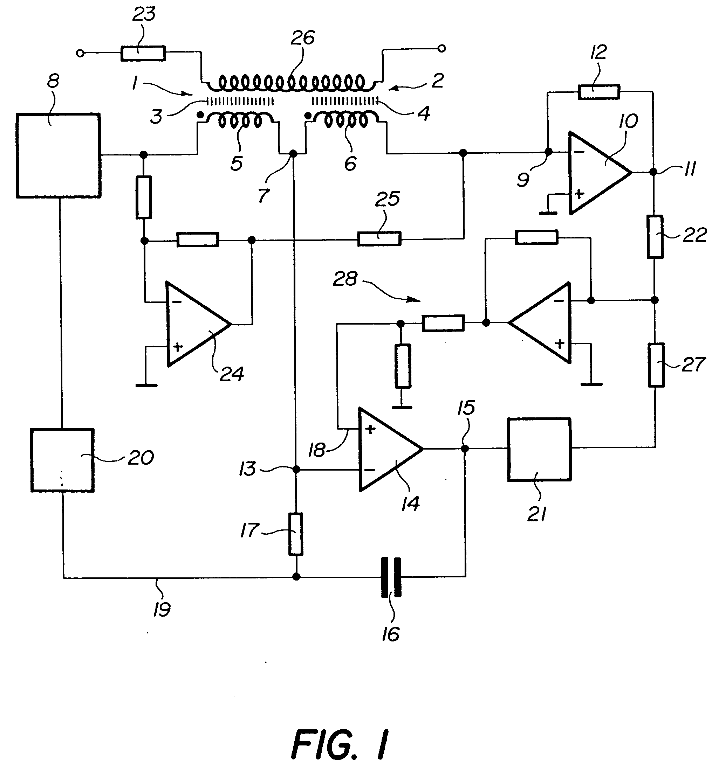

la Fig. 1 montre un schéma électrique simplifié d'un tel dispositif de mesure.

Dans le schéma de la Fig. 1, les références 1 et 2 désignent deux transformateurs de courant ayant des noyaux magnétiques respectifs 3 et 4, par exemple sous forme de tores en un matériau magnétique à haute perméabilité. Ces transformateurs comportent un enroulement primaire, de préférence un enroulement commun 26 ou un conducteur primaire commun, couplé avec les deux tores et parcouru par le courant à mesurer Ip. Les enroulements secondaires de chacun des transformateurs sont désignés, respectivement, par 5 et 6, ces enroulements présentant un point de connexion commun 7 et étant bobinés de façon que le courant primaire y induise des courants parcourant ces enroulements dans le même sens.

Une tension alternativement positive et négative est appliquée à l'enroulement 5 par un générateur 8, de manière à faire circuler, dans cet enroulement, un courant magnétisant qui amène le noyau 3 périodiquement en état de saturation dans le sens positif et négatif. Un courant de mesure du courant primaire est également fourni par le générateur 8, et se superpose au courant magnétisant.

La borne de l'enroulement 6 non-reliée au point de connexion commun 7 est connectée à une entrée négative 9 d'un amplificateur 10 dont la sortie 11 est couplée, par l'intermédiaire d'une résistance 12 de valeur R, à cette même entrée 9. L'entrée positive de l'amplificateur 10 est connectée à la masse du circuit.

Les enroulements secondaires 5 et 6 présentent chacun le même nombre de spires $N_s$, le nombre de spires de l'enroulement primaire étant désigné par $N_p$. Dans les conditions à réaliser dans le présent dispositif, notamment qu'aucune fraction du courant de magnétisation circulant dans l'enroulement 5, ne passe dans l'enroulement 6, la tension U apparaissant à la sortie 11 de l'amplificateur et représentant le signal de mesure du courant primaire, a la valeur

$$U = I_p \cdot R \cdot N_p / N_s.$$

Selon une première particularité du dispositif, le point de connexion commun des enroulements secondaires 5 et 6 est relié à une borne d'entrée négative 13 d'un amplificateur 14, et la sortie 15 de cet amplificateur est couplée, par l'intermédiaire d'un condensateur 16 ainsi que d'une résistance 17 connectée en série avec le condensateur 16, à la borne d'entrée 13. Un potentiel de polarisation, obtenu d'une manière décrite plus loin, est appliqué à une seconde entrée 18, positive, de l'amplificateur 14.

Le couplage capacitif entre la sortie 15 et l'entrée 13 de l'amplificateur 14 maintient le potentiel du point 7 sensiblement à une valeur indépendante des variations dues au courant magnétisant. Ainsi, le courant de magnétisation passe entièrement dans la branche 7, 13, 17 et n'est pas dévié dans l'enroulement 6. Aux bornes de la résistance 17 apparaît une chute de tension qui est utilisée, par l'intermédiaire d'une connexion 19 et d'un dispositif de commande 20, pour commander le générateur 8, c'est-à-dire pour déclencher l'inversion de la tension de sortie de ce générateur chaque fois qu'un état de saturation est atteint dans le noyau 3, c.à.d. chaque fois que la chute de tension dans la résistance 17 atteint des seuils positif et négatif prédéterminés.

Le potentiel de polarisation de l'entrée 18 de l'amplificateur 14 est dérivé, d'une part, du signal de sortie de cet amplificateur qui est d'abord filtré dans un filtre passe-bas 21, puis appliqué par un circuit résistif 27,28 à l'entrée 18 et, d'autre part, du signal de mesure apparaissant à la borne de sortie 11 de l'amplificateur 10 et additionné, par l'intermédiaire d'une résistance 22, au signal issu de l'amplificateur 14. Les différentes résistances sont calculées notamment de façon à compenser la chute de tension dans l'enroulement secondaire 6 du transformateur 4, toute variation de cette chute de tension produisant instantanément une variation correspondante du potentiel de polarisation à l'entrée 18. La boucle de contre-réaction de l'amplificateur 14 aboutissant à l'entrée 18 est dimensionnée de façon à éviter que la tension de sortie de l'amplificateur n'atteigne le seuil de saturation de cet amplificateur. Le potentiel de polarisation résultant à l'entrée 18 compense ainsi également les tensions d'offset des amplificateurs 10 et 14.

Dans le cas d'un dispositif destiné à la mesure isolée de tensions, une résistance 23 est connectée, dans le circuit primaire, en série avec l'enroulement primaire 26 des transformateurs 1 et 2 qui, en l'occurrence, comporte un nombre de spires relativement élevé par rapport au cas de la mesure d'un courant proprement dit. D'autre part, un signal est dérivé de la sortie du générateur 8 et est appliqué, en passant par un inverseur 24 et une résistance de calibrage 25, à l'entrée 9 de l'amplificateur 10. Les différentes résistances sont calculées de façon que l'effet du courant induit dans l'enroulement primaire 26 par les variations de la tension du générateur 8 appliqué à l'enroulement 5, soit compensé par le courant de signe opposé fourni par le circuit 24, 25. Ceci permet d'éliminer l'influence de l'ondulation du courant primaire due à la magnétisation du transformateur 1, sur le signal de mesure à la sortie 11 de l'amplificateur 10.

## Revendications

1. Dispositif de mesure de courants comportant un premier transformateur de courant (1) avec un conducteur ou enroulement primaire (26) agencé pour être parcouru par le courant à mesurer, un enroulement secondaire (5) et un noyau magnétique (3) saturable par un courant magnétisant fourni audit enroulement secondaire, un second transformateur de courant (2) à noyau magnétique (4) comprenant un conducteur ou enroulement primaire (26) agencé pour être parcouru par le courant à mesurer, un enroulement secondaire (6) ayant le même nombre de spires que l'enroulement secondaire (5) dudit premier transformateur (1), ayant un point de connexion (7) commun avec cet enroulement secondaire (5) dudit premier transformateur (1) et étant agencé de façon que les courants induits dans ces deux enroulements par le courant à mesurer parcourent ces enroulements dans le même sens, un générateur de courant (8) agencé et connecté audit enroulement secondaire (5) du premier transformateur (1) de façon à faire circuler dans celui-ci un courant comprenant une composante, désignée par courant magnétisant, capable d'amener le noyau (3) alternativement dans les états de saturation positive et négative, un dispositif (17,19,20) pour commander ce générateur à partir du courant magnétisant et un dispositif (10, 12) pour mesurer le courant circulant dans l'enroulement secondaire (6) du second transformateur (2), courant qui est proportionnel au courant à mesurer, et pour fournir un signal de mesure, caractérisé en ce qu'il comporte des moyens pour compenser les variations du potentiel dues au courant magnétisant au point de connexion commun (7) des deux enroulements secondaires, ces moyens comprenant un amplificateur opérationnel (14) dont une première entrée (13), négative, est reliée audit point de connexion commun et dont la sortie est couplée, par l'intermédiaire d'un condensateur (16) et d'une résistance de mesure (17) du courant magnétisant, à ladite première entrée (13), un potentiel de polarisation étant appliqué à une deuxième entrée (18), positive, dudit amplificateur opérationnel (14), et en ce qu'il comporte un circuit (21,22,27,28) pour produire ledit potentiel de polarisation à partir du signal de mesure et du signal de sortie dudit amplificateur (14), de façon que ce potentiel de polarisation soit déterminé par un signal essentiellement proportionnel à l'inverse du signal de mesure et par un signal obtenu à partir du signal de sortie dudit amplificateur, de manière à ce que lesdits moyens compensent aussi automatiquement les chutes de tension produites par le courant induit dans l'enroulement secondaire (6) du second transformateur (2) par le courant à mesurer et les tensions d'offset d'amplificateurs (10, 14) du dispositif pouvant affecter le signal de mesure.

2. Dispositif selon la revendication 1, modifié pour la mesure de tensions, dans lequel le ou les enroulements primaires (26) comportent un nombre de spires relativement élevé par rapport au cas de la mesure d'un courant en tant que tel, et sont connectés en série avec une résistance (23) dans un circuit primaire, caractérisé en ce qu'il comporte un circuit (24,25) de compensation de l'effet des ondulations apparaissant, par induction, dans le courant du circuit primaire, du fait des variations du courant magnétisant dans l'enroulement secondaire (5) du premier transformateur (1), ce circuit de compensation comprenant des moyens pour obtenir à partir des variations du courant de sortie du générateur (8) un signal de compensation de ces ondulations dans le signal de mesure.

## Patentansprüche

1. Vorrichtung zum Messen von Strömen, die einen ersten Stromwandler (1) aufweist mit einem Primärleiter oder einer Primärwicklung (26), die dazu ausgebildet sind, von dem zu messenden Strom durchflossen zu werden, mit einer Sekundärwicklung (5) und einem magnetischen Kern (3), der von einem der genannten Sekundärwicklung zugeführten Magnetisierungsstrom zur Sättigung gebracht werden kann, einen zweiten, einen magnetischen Kern (4) aufweisenden Stromwandler (2), welcher einen Primärleiter oder eine Primärwicklung (26) besitzt, die dazu ausgebildet sind, von dem zu messenden Strom durchflossen zu werden, eine Sekundärwicklung (6), welche die gleiche Anzahl Windungen aufweist wie die Sekundärwicklung des genannten ersten Wandlers (1), einen gemeinsamen Verbindungspunkt (7) mit dieser Sekundärwicklung (5) des genannten ersten Wandlers (1) hat und so ausgebildet ist, dass die in diesen beiden Wicklungen durch den zu messenden Strom induzierten Ströme diese Wicklungen in der gleichen Richtung durchfliessen, einen Stromgenerator (8), der so ausgebildet ist und so mit der genannten Sekundärwicklung (5) des ersten Wandlers (1) verbunden ist, dass er in diesem das Fliessen eines Stromes hervorruft, der eine als Magnetisierungsstrom bezeichnete Komponente aufweist, die geeignet ist, den Kern (3) abwechselnd in den positiven und den negativen Sättigungszustand zu bringen, eine Vorrichtung (17, 19, 20), um diesen Generator von dem Magnetisierungsstrom aus zu steuern, und eine Vorrichtung (10, 12), um den in der Sekundärwicklung (6) des zweiten Wandlers (2) fliessenden Strom zu messen, welcher proportional dem zu messenden Strom ist, und um ein Meßsignal zu liefern, dadurch gekennzeichnet, dass sie Mittel zur Kompensierung der infolge des Magnetisierungsstromes im gemeinsamen Verbindungspunkt (7) der beiden Sekundärwicklungen auftretenden Potentialschwankungen aufweist, wobei diese Mittel einen Operationenverstärker (14) enthalten, dessen erster, negativer Eingang (13) mit dem genannten gemeinsamen Verbindungspunkt verbunden ist und dessen Ausgang über einen Kondensator (16) und einen Widerstand (17) zur Messung des Magnetisierungsstromes mit dem genannten ersten Eingang (13) verbunden ist, wobei ein Polarisierungspotential an einen zweiten, positiven Eingang (18) des genannten Operationenverstärkers (14) angelegt wird, und dass er eine Schaltung (21, 22, 27, 28) aufweist, um das genannte Polarisierungspotential, ausgehend vom Meßsignal und vom Ausgangssignal des genannten Verstärkers (14) zu erzeugen, so dass dieses Polarisierungspotential von einem dem umgekehrten Meßsignal im wesentlichen proportionalen Signal und von einem aus dem Ausgangssignal des genannten Verstärkers gewonnenen Signal bestimmt wird, in solcher Weise, dass die genannten Mittel auch die Spannungsabfälle automatisch kompensieren, die durch den in der Sekundärwicklung (6) des zweiten Wandlers (2) durch den von dem zu messenden Strom induzierten Strom erzeugt werden, und die Offset-Spannungen von Verstärkern (10, 14) der Vorrichtung, welche das Meßsignal beeinflussen können.

2. Vorrichtung nach Patentanspruch 1, die zur Messung von Spannungen abgeändert ist, in der die Primärwicklung oder -wicklungen (26) eine relativ hohe Windungszahl im Vergleich zum Fall der Messung eines Stromes als solchen aufweisen und in Serie mit einem Widerstand (23) in einen Primärkreis geschaltet sind, dadurch gekennzeichnet, dass sie eine Schaltung (24, 25) zur Kompensation der Wirkung der Welligkeiten aufweist, die durch Induktion im Strom des Primärkreises infolge der Schwankungen des Magnetisierungsstroms in der Sekundärwicklung (5) des ersten Wandlers (1) auftreten, wobei diese Kompensationsschaltung Mittel aufweist, um aus den Schwankungen des Ausgangsstroms des Generators (8) ein Kompensationssignal für diese Welligkeiten im Meßsignal zu gewinnen.

## Claims

1. A current measuring device comprising a first current transformer (1) with a primary conductor or winding arranged for carrying the current to be measured, a secondary winding (5) and a magnetic core (3) capable of being saturated by a magnetizing current delivered to said secondary winding, a second current transformer (2) with a magnetic core (4) comprising a primary conductor or winding (26) arranged for carrying the current to be measured, a secondary winding (6) having the same number of turns as the secondary winding (5) of said first transformer (1), having a common connection point (7) with this secondary winding (5) of said first transformer (1) and being arranged so as to produce in the same the flow of a current comprising a component, designated as magnetizing current, capable of driving the core (3) alternatively into positive and negative states of saturation, a device (17, 19, 20) for controlling this generator by the magnetizing current and a device (10, 12) for measuring the current flowing in the secondary winding (6) of the second transformer (2), which current is proportional to the current to be measured, and for providing a measuring signal, characterized in that it comprises means for compensating the variations of potential due to the magnetizing current at the commun connection point (7) of the two secondary windings, these means comprising an operational amplifier (14), a first negative input (13) of which is connected to the said commun connection point and the output of which is coupled, through a condenser (16) and a resistor (17) for measuring the magnetizing current, to said first input (13), a biasing potential being applied to a second, positive, input (18) of said operational amplifier (14), and in that it comprises a circuit (21, 22, 27, 28) for producing said biasing potential from the measuring signal and from the output signal of said amplifier (14) in such a way that this biasing potential is determined by a signal substantially proportional to the inverse of the measuring signal and by a signal obtained from the output signal of said amplifier, so that said means also compensate automatically for the voltage drops produced by the current induced in the secondary winding (6) of the second transformer (2) by the current to be measured, and for the offset voltages of amplifiers (10, 14) of the device which can affect the measuring signal.

2. A device according to claim 1, modified for the measurement of voltages, in which the primary winding or windings (26) comprise a relatively high number of turns as compared to the case of the measurement of a current as such, and are connected in series with a resistor (23) in a primary circuit, characterized in that it comprises a compensation circuit (24, 25) for compensating the effect of ondulations appearing by induction in the primary current due to the variations of the magnetizing current in the secondary winding (5) of the first transformer (1), this compensation circuit comprising means for obtaining from the variations of the output current of the generator (8) a signal compensating these ondulations in the measuring signal.

FIG. 1